Europäisches Patentamt

European Patent Office

Office européen des brevets

(19)

(11) Publication number: **0 178 148**
**A2**

(12) # EUROPEAN PATENT APPLICATION

(21) Application number: 85307177.7

(22) Date of filing: 08.10.85

(51) Int. Cl.⁴: **H 01 L 31/10, H 01 L 31/02**

(30) Priority: 09.10.84 US 659063

(43) Date of publication of application: 16.04.86
Bulletin 86/16

(84) Designated Contracting States: DE FR GB

(71) Applicant: **XEROX CORPORATION, Xerox Square - 020,
Rochester New York 14644 (US)**

(72) Inventor: **Johnson, Noble M., 128 Cornell Road, Menlo
Park California 94025 (US)**
Inventor: **Chiang, Anne, 10213 Miner Place, Cupertino
California 95014 (US)**

(74) Representative: **Weatherald, Keith Baynes et al,
European Patent Attorney Rank Xerox Limited Patent
Department 338 Euston Road, London NW1 3BH (GB)**

(54) **Thin film photodetector.**

(57) A two-terminal thin film semiconductor photodetector
comprises a dopant-modulated channel in the photodetector
thin film that provides for long electron lifetime and, as a result,
has equivalent or superior photosensitivity compared to deple-
tion mode TFT devices without the need for or utilization of a
gate electrode and the application of a gate voltage. The two-
terminal thin film photodetector comprises, e.g., a semicon-
ductor thin film of crystalline silicon on an insulating substrate
(12) having two terminal regions (26, 28) and a thin film light-
sensitive channel formed between the two terminal regions.
The channel comprises three distinct doped regions in the thin
film: a region of first conductivity type (14) formed immediate-
ly adjacent to the substrate, a second region (16) of opposite
conductivity type formed over the first region, and a third region (18) of the same conductivity type as the first region,
formed over the second region. The doped regions form p-n
junctions (15, 17) located parallel to the surface of the substrate between the first and second regions and the second and
third regions. These junctions function as a charge carrier separation means. The channel functions as fully depleted in the
dark and becomes photoconducting when illuminated.

# THIN FILM PHOTODETECTORS

This invention relates to semiconductor photodetector devices and more particularly to two-terminal dopant-modulated thin film semiconductor photodetectors, which are especially suited for use in large area image sensor arrays.

Because of its ease of deposition on transparent substrates over a large area and ease to obtain reproducibe electronic device operations, devices in crystallized silicon thin films show great potential in applications including large area displays, photodetectors, image sensors and integrated optics.

Because of its photosensitivity, silicon has been employed in photosensors in the configurations of photodiodes, phototransistors and charge-coupled devices. Ordinarily, these configurations are fabricated on bulk single-crystalline silicon substrates. The overall size of such configurations is limited by the size of the silicon wafer. The use of light collection optics for reading a large image area requires a bulky sensing system.

Because of the ease of deposition of amorphous silicon (a-Si:H) thin films on transparent substrates of arbitrarily large size, these thin films have been employed in large area image sensor arrays for contact document input scanners. See, for example, US-A-4,419,696. However, because of the low carrier mobilities in a-Si:H, the photosensitivity and the speed are, in general, found to be poorer when compared with sensors fabricated in bulk crystalline silicon (c-Si).

Recent progress in laser crystallization has enabled formation of defect-free, single crystalline silicon thin films on bulk amorphous substrates for formation of high performance TFT's to permit applications to direct view large area electronic devices such as flat panel displays and image sensors on transparent substrates, see for example, US-A-4,409,724. Recent demonstration of TFT shift registers also promises to broaden the field of application from local switching of individual transducers to include logic circuits having sufficiently high speed for data rates often encountered in image processing. See, for example, A. Chiang et al., in "NMOS Logic Circuits in Laser Crystallized Silicon on Quartz", Proceedings of the 1983 Materials Research Society, Boston, Massachusetts, November, 1983, and published in the book. Energy Beam-Solid Interactions & Transient Thermal Processing, John C. C. Fann and N. M. Johnson, editors, Vol. 23, pp. 551-558, (Elsevier, New York, 1984).

Crystallization of silicon thin films on insulating substrates, e.g., fused quartz, in patterned and encapsulated configuration by a scanned CW laser have been well documented in the art, see, for example, US-A- 4,330,363 and the book, Laser & Electron-Beam Solid Interactions & Materials Processing, J.F. Gibbons et al, editors, Vol. 1, in particular the article of N. M. Johnson et al. at pages 463-470 entitled, "Processing and Properties of CW Laser-Recrystallized Silicon Films on Amorphous Substrates" (Elsevier, New York, 1981). The recent technological breakthrough involves using a solidification front tilted from the path of the molten zone of the scanned CW laser. Structural defects can be greatly reduced or even eliminated by a lateral defect-sinking thus permitting formation of very high percentage of (100)-textured single crystalline silicon islands with <100> in-plane orientations. See the Proceedings of the 1983 Materials Research Society Meeting, supra and L. Fennell et al., "Defect Reduction by Tilted Zone Crystallization of Patterned Silicon Films on Fused Silica, and published in the book, Energy Beam-Solid Interactions & Transient Thermal Processing, John C. C. Fann and N. M. Johnson, editors, Vol. 23, pp. 403-408, (Elsevier, New York, 1984).

These advances in the technology of laser crystallized silicon thin films on insulating substrates have produced numerous novel NMOS and CMOS thin film electronic devices with performances comparable with, or superior to, those of bulk devices. However, the photosensitivity demonstrated in enhancement mode TFT's has not been sufficiently great to provide a desired level of S/N ratio and dynamic range for contact input scanner applications such as high speed, high resolution in compact electronic copiers, printers or facsimile machines.

According to this invention, a two-terminal thin film photodetector comprises a dopant-modulated channel in the semiconductor photodetector thin film that provides for long electron lifetime and, as result, has high photosensitivity without the need for, or utilization of, a gate electrode and the application of a gate voltage.

The two-terminal thin film photodetector of this invention comprises, e.g., a semiconductor thin film crystalline silicon on an insulating substrate having two terminal regions, and a thin film light-sensitive channel formed between the two terminal regions. The channel comprises three distinct doped regions

- 3 -

0178148

in the thin film: a region of first conductivity type formed immediately adjacent to the substrate, a second region of opposite conductivity type formed over the first region, and a third region of the same conductivity type as the first region formed over the second region. The doped regions form p-n junctions located parallel to the surface of the substrate between the first and second regions and the second and third regions. These junctions function as a charge carrier separation means. The channel functions as fully-depleted in the dark and becomes photoconducting when illuminated.

The upper- and lower-most regions, for example, may be p regions that function as a storage zone for holes, while the central region may be an n region that functions as a current channel between the two $n^+$ terminal regions of the photodetector and forming a storage zone or potential well for electrons. The $n^+$ terminal regions function as ohmic contacts to the n channel region. The photodetector of this invention exhibits high photoconductive gain with low dark current because of the p-n-p channel configuration in the thin film.

The present invention will now be described by way of example with reference to the accompanying drawings, in which:

Figure 1 is a schematic illustration of a two-terminal thin film photodetector of this invention, and

Figure 2 is an energy band diagram for the channel region of the two-terminal thin film photodetector of Figure 1.

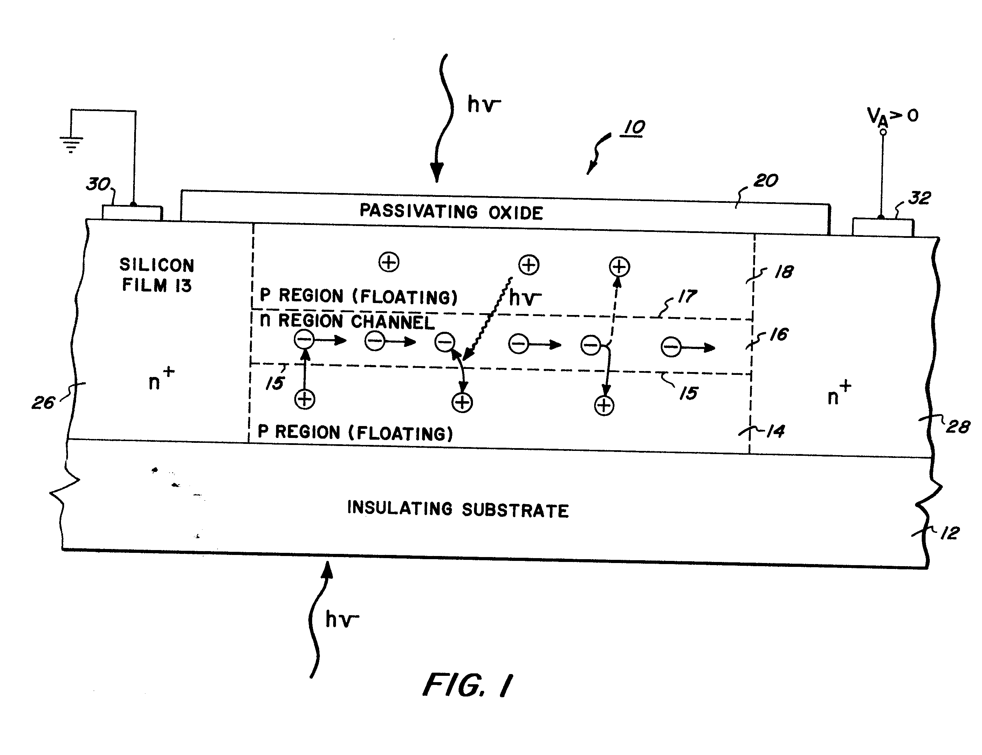

Referring now to Figure 1, there is schematically illustrated the two-terminal dopant-modulated thin film photodetector 10 of this invention. Photodetector 10 comprises a buried-channel thin film device on a transparent and insulating substrate 12, such as fused quartz or fused silica. Substrate 12 may be comprised of other insulating material, such as glass or ceramic plates. The transparency of substrate 12 is useful for sensing light at the photodetector through the substrate, although fabrication also permits transmission of light through the surface passivating oxide 20 of the photodetector. In any case, substrate 12 may be chosen to be transparent or opaque depending upon the desired design for light transmission to an integrated semiconductor array including photodetectors 10 of this invention.

Photodetector 10 may comprise, for example, a crystallized silicon thin film 13 which is patterned by photolithography into a discrete island. Film 13 may be, for example, 0.5 µm thick. The thickness for film 13 may be in the range, for example, of about 0.3 µm to 50 µm.

Film 13 is inhomogenously doped by conventional techniques (e.g., ion implantation) to form a p-n-p dopant configuration in the film. The channel comprises a lower p type region 14 (e.g. boron), a central n type channel region 16 (e.g. phosphorus) and an upper p type region 18 (e.g. boron). The lower region 14 and the channel region 16 form a p-n junction 15, and the upper region 18 and the channel region 16 form a p-n junction 17. Oxide layer 20 is thermally grown by oxidizing a portion of the silicon film 13 and may, for example, be about 0.13 µm thick. The purpose of oxide layer 20 is to passivate the semiconductor surface of film 13. The two terminal regions 26 and 28 are formed on opposite sides of the "tri-regions" 14-16-18 by $As^+$ implantation to form highly doped $n+$ regions functioning as ohmic contacts to central channel region 16. Electrodes 30 and 32 at terminal regions 26 and 28 may be comprised of vapor-deposited Al.

Photodetector 10 may be formed by fabrication techniques known in the art. For example a 0.5 µm thick layer of LP-CVD polysilicon on a fused quartz wafer may be delineated by photolithography and plasma etching to provide a plurality of patterned stripes which are then subjected to a laser melting treatment to bring about recrystallization. Laser crystallization is accomplished with a scanned CW $CO_2$ laser spot which is offset from the center of the islands to generate a tilted solidification front which it is scanned across each of the islands. This technique produces predominantly (100)-textured, and <100>-oriented crystal silicon islands within the stripes, which do not contain sub-grain boundaries. After laser crystallization, fabrication of the photodetectors may be carried out, for example, with an NMOS process with six mask levels as described in the previous paragraph and in A. Chiang et al, Proceedings of SPIE Symposium on Laser Processing of Semiconductor Devices Vol. 385, 76 (1983), and in the book Energy Beam - Solid Interactions & Transient Thermal Processing, supra.

The lower p region 14 in photodetector 10 is formed by implantation of boron ions through oxide layer 20 to give an acceptor concentration of about $10^{17}/cm^3$ in region 14 of layer 13. Similarly, the n channel region 16 is formed by implantation of phosphorus ions to achieve a donor concentration of comparable density in the central region 16 of layer 13. Lastly, p region 18 is formed by implantation of boron ions through oxide layer 20 to give an acceptor concentration of about $10^{17}/cm^3$. The acceptor and donor concentration may be in the range of $10^{15}/cm^3$ to $10^{18}/cm^3$.

The expected performance of photodetector 10 can be estimated from that of the depletion mode TFT in pinch off. The silicon island forming photodetector 10 is about 0.5 µm thick and absorbs only 25% of the incident light, the fundamental photoconductive gain, G, may be as large as 3440 electrons/absorbed photon, if reflection is ignored and unity quantum efficiency is assumed. Such a large gain in an n type photodetector with ohmic contacts implies a very long electron lifetime which can be estimated from an alternative definition for photoconductive gain, G set forth in Equation (1).

$$G = \tau/t_n \qquad\qquad (1)$$

where $\tau$ is equal to the lifetime of photoelectron before recombination with a hole, and $t_n$ is equal to the transit time of an electron in channel region 16 and is determined by Equation (2).

$$t_n = L^2/\mu_n V_D \qquad\qquad (2)$$

where L is equal to the channel length, $\mu_n$ is equal to the electron mobility, and $V_D$ is equal to voltage applied across channel. This yields an estimate of the electron lifetime for $\mu_n$ approximately 2000 $cm^2/V_s$ and with $V_D = 0.1$ V, the lifetime is approximately 60 µs. Thus, the high photoconductivity of the depletion mode TFT, and, therefore, of the two-terminal photodetectors, reveals long electron lifetimes.

The photodetector 10 of this invention basically differs from depletion mode TFT photodetectors by (1) the employment of p region above as well as below the n channel region, and (2) the elimination of a gate electrode.

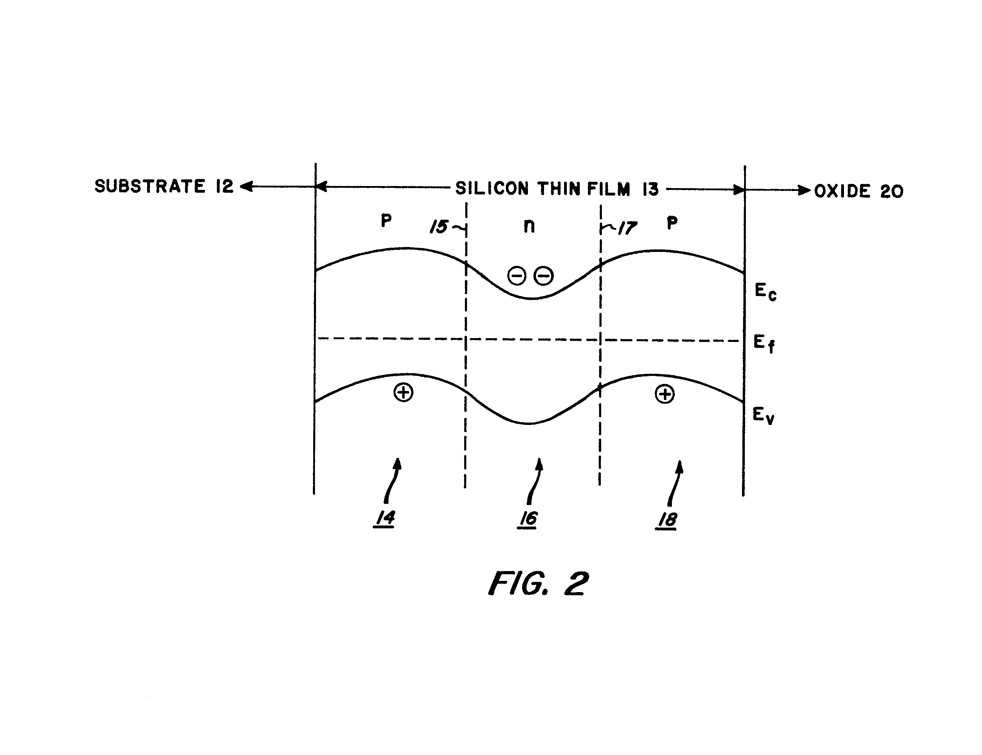

The physics of photodetector 10 can be qualitatively explained with the aid of an energy band diagram of regions 14, 16 and 18 disclosed in Figure 2. The solid lines $E_C$ and $E_V$, respectively, represent the conduction and valence bands, while the dotted line, $E_f$, represents the Fermi level. As an example, the metallurgical junctions 15 and 16 in the silicon thin film 13 may be located, respectively, approximately 0.3 µm and 0.2 µm beneath oxide layer 20, with channel region 16 having a width of approximately 0.1 µm between p-n junctions 15 and 17.

Both p regions 14 and 18 are electrically floating and the depletion layers of p-n junctions 15 and 17 merge to form a potential energy minimum or well within n channel region which contains a negligible density of thermally generated free electrons. As a result, the dark current is negligible. Similarly, a potential energy well for holes exists in both p regions 14 and 18, each of which are bounded from one side by a junction depletion region and from the other side by electrostatic repulsion of free holes away from unavoidable and fixed residual positive space charge present in an adjacent SiO2 layer, i.e., respectively, the fused silica substrate 12 or the thermal oxide layer 20. As illustrated in Figure 2, photogenerated electron-hole pairs tend to segregate across the p-n junctions 15 and 17 and collect in their respective wells, with excess holes contributing a static positive space charge in the floating p regions 14 and 18 which partially compensates the negative acceptor charge. A corresponding effect occurs with the excess electrons in the n region 16. The additional space charge lowers the potential barrier of junctions 15 and 17. The electrons contribute to photocurrent until they recombine with holes.

Under constant illumination, the charge separation reaches a steady-state condition with each type of carrier making a distinct contribution to photoconductivity. Holes remain in both floating p regions 14 and 18 as space charge, while electrons in the buried channel region 16 contribute to photocurrent until they recombine with holes across p-n junctions 15 and 17. As the electrons are electrostatically confined in the buried channel 16 away from the holes in the p regions 14 and 18, the recombination process is greatly inhibited and long electron lifetimes are possible. Thus, large photocurrents arise from the localization of excess positive charge in floating p regions 14 and 18 which electrostatically draw negative charge into the channel region 14 from the terminal region 26 as excess electrons drift out at terminal region 28. The amount of photocurrent produced is proportional to the amount of light impinging upon channel 13.

Consequently, the photoelectrons effectively contribute to the photocurrent for times exceeding the transit time of the channel, giving rise to a photoconductive gain G, as defined in Equation (1), which is much greater than unity.

In particular, the introduction of the tri-region 14-16-18 in film 13 forms a p-n-p channel configuration providing a new fundamental feature relative to charge separation. In Figure 1, there is illustrated electron-hole generation by absorption of a photon of energy, hv, charge separation because of electrostatic inhomogeneity of the lateral p-n junctions 15 and 17, and possible recombination events involving charge diffusion across the junctions 15 and 17. Upon the application of light to photodetector 10, photogenerated free holes are divided between the two floating p regions. The combined number of photogenerated holes in the two p regions equals the number of photogenerated electrons in the n conducting channel 16. Thus, for a given areal density of photoexcited electrons in channel 16, part of that density of holes exists on one side of channel 16 (e.g., region 14) and the remainder exists on the other side of channel 16 (e.g., region 18). This leads to less reduction in the electrostatic potential across each junction because of the spatially-separated free electrons and holes and, therefore, provides a higher potential barrier at the junction interface regions. In turn, an increase in barrier height supralinearly reduces the recombination rate, for example, by reducing the rate of diffusion of free carriers across junctions 15 and 17, which increases the carrier lifetime and, therefore, the optical gain.

Further, the two-terminal photodetector of this invention offers both practical as well as fundamental advantages over a depletion mode TFT photodetector. Eliminating the gate electrode results in a simpler device structure requiring fewer processing steps in device fabrication, less complexity in circuitry, hence, fewer process-related defects. This significantly contributes to higher device/circuit yields. For example, pin holes in passivating layer 20 will have no direct effect on device operation, while in three terminal TFT photodetector, pin holes may result in electrical short-circuits between the gate electrode and the channel. Further, the removal of the gate electrode increases the incident light responsivity or photosensitivity and also the "blue" spectrum response in the case of top illumination because of the elimination of optical absorption present in a partially-transparent gate electrode.

To summarize, the major contributing factors for high level of photosensitivity in the photodetector of this invention are:

(1) formation of p-n junctions 15 and 17 for charge separation with the fabrication of dual p regions 14 and 18 separated by a thin n region 16 forming a photoconduction channel,

(2) excellent quality of single crystalline thin films achieved in this particular manner of crystallization, leaving little defects or grain boundaries in the bulk of the thin film to serve as recombination centers, and

(3) higher electron mobility for a buried channel as compared to that for a surface channel.


While the invention has been described in conjunction with a few specific mbodiments, it is evident to those skilled in the art that many alternatives, modifications and variations will be apparent in light of the foregoing description. For example, reverse polarity of the dopants for photoconduction with holes can be accomplished by doping regions 26 and 28 as $p^+$ and upper and lower regions 14 and 18 doped n and channel region 16 doped p.

Claims:

1. A two-terminal thin film photodetector (10) comprising a crystalline silicon thin film (13) on an insulating substrate (12) having two terminal regions (26, 28) and a thin film light-sensitive channel formed between them, the channel comprising three distinct regions in the thin film, a region (14) of first conductivity type formed immediately adjacent to the substrate, a second region (16) of opposite conductivity type formed over the first region, and a third region (18) of the same conductivity type as the first region formed over the second region, p-n junctions (15, 17) located parallel to the surface of the substrate in the thin film channel and between the first and second regions, and the second and third regions, the junctions functioning as a charge carrier separation means, the channel being fully depleted in the dark and photoconducting when said photodetector is subjected to light, providing for high dynamic range and large photocurrent operation.

2. The two-terminal thin film photodetector of claim 1, wherein said channel comprises a p-n-p channel configuration, the terminal regions comprising n+ regions at the ends of the channel and functioning as ohmic contacts to the n channel region, the photodetector having high photoconductive gain under an applied bias.

3. The two-terminal thin film photodetector of claim 1 wherein the second region is doped n type, and the first and third regions are doped p type.

4. The two-terminal thin film photodetector of claim 1, wherein said channel comprises a n-p-n channel configuration, the terminal regions comprising p+ regions at the ends of the channel and functioning as ohmic contacts to the n channel region, the photodetector having high photoconductive gain under an applied bias.

5.    The two-terminal thin film photodetector of any preceding claim, wherein there is a passivating oxide layer (20) formed over the third region, the passivating oxide layer being transparent.

6.    The two-terminal thin film photodetector of any preceding claim, wherein the insulating substrate is transparent.

7.    The two-terminal thin film photodetector of any preceding claim, wherein the acceptor and donor concentrations and profiles are chosen to permit photoconduction in the second region, with the second region being fully depleted in the dark.

8.    The two-terminal thin film photodetector of claim 7, wherein the acdceptor and donor concentrations respectively in the first and third regions and the second region are in the range from $10^{15}/cm^3$ to $10^{18}/cm^3$.

9.    The two-terminal thin film photodetector of any preceding claim, wherein the thickness of the channel is in the range of $0.3\mu m$ to $50\mu m$.

10.    The two-terminal thin film photodetector of any preceding claim, formed by laser melting treatment to bring about recrystallization of the thin film.

FIG. 1

SUBSTRATE 12 ← | SILICON THIN FILM 13 | → OXIDE 20

P  15~  n  ~17  P

⊖ ⊖

$E_c$

$E_f$

⊕  ⊕  $E_v$

14  16  18

**FIG. 2**